# EUROPEAN PATENT APPLICATION

(11) **EP 1 271 641 A1**
(43) Date of publication of application: **02.01.2003**
(21) Application number: 01912175.5
(22) Date of filing: 08.03.2001
(51) Int. Cl.: H01L 21/60

(54) **METHOD AND APPARATUS FOR MOUNTING CHIP**

(30) Priority: 10.03.2000 JP 2000067349
(71) Applicant: TORAY ENGINEERING CO., LTD., Kita-ku, Osaka-shi, Osaka 530-0005 (JP)
(72) Inventor: TERADA, Katsumi, c/o Toray Engineering Co., Ltd, Otsu-shi, Shiga 520-2141 (JP); YAMAUCHI, Akira, c/o Toray Engineering Co., Ltd, Otsu-shi, Shiga 520-2141 (JP)
(74) Representative: Schmitz, Hans-Werner, Dipl.-Ing.
(86) International application number: JP0101799
(87) International publication number: WO01067506

(57) **Abstract**

In bonding bumps formed on a chip to electrodes formed on a substrate in a purge gas atmosphere, purge gas is supplied locally at least around the bumps, with the substrate and the chip separated from each other. According to the method and apparatus for chip mounting, the concentration of purge gas can be increased locally around the bumps where the isolation from the air is required, so that the bumps are protected effectively from secondary oxidation.

## Description

### Technical Field of the Invention

The present invention relates to a method and an apparatus for mounting a chip, and specifically to chip mounting method and apparatus which can effectively prevent secondary oxidation of bumps (oxidation originating from heating) when a chip is mounted on a substrate.

### Background Art of the Invention

A chip mounting method is well known, wherein a bump is formed on a chip, the chip is approached to a substrate in a form of face down, and after the bump is brought into contact with an electrode of the substrate, the bump of the chip is heated and molten to be bonded to the electrode of the substrate. In such a chip mounting method using a bump, there is a fear that the bump is secondarily oxidized in an oxidization gas atmosphere by heating. If such a secondary oxidation occurs, namely, if an oxide is present on the surface of the bump, there is a fear that a desired bonding between the bump and the electrode of the substrate cannot be achieved. Since usually gold is plated on an electrode of a substrate, there is no fear that secondary oxidation occurs on the side of the electrode of the substrate.

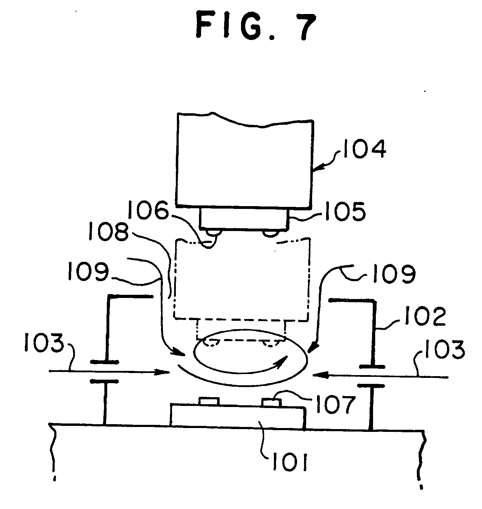

In order to prevent the secondary oxidation of a bump, a method for blowing nitrogen gas into a gap between a chip and a substrate is known, and in the method, the bump is bonded to an electrode of the substrate in the nitrogen gas atmosphere. For example, as shown in Fig. 7, a chamber 102 is provided so as to surround a substrate 101, the air in the chamber 102 is substituted for nitrogen gas by blowing nitrogen gas 103 into the chamber 102, and at the same time a chip 105 held by tool 104 is moved down from upper side, and bumps 106 of the chip 105 are bonded to electrodes 107 of the substrate 101 in the nitrogen gas atmosphere in the chamber 102.

However, in the above-described conventional method using chamber 102, especially the external air 109 is involved from an opening 108 formed for the vertical movement of tool 104, and in practice, it is difficult to increase the concentration of the nitrogen gas in chamber 102 up to a concentration effective to prevent the secondary oxidation.

Further, although only the portions around bumps may be sealed from the oxidization air by the nitrogen gas from the viewpoint of prevention of secondary oxidation, because the nitrogen gas is blown into the whole of the inside of chamber 102 and the involved air flows vortically or randomly in the chamber102, the concentration of nitrogen gas cannot be increased only around the bumps.

### Disclosure of the Invention

Accordingly, an object of the present invention is to provide method and apparatus for mounting a chip which can efficiently increase the concentration of purge gas (for example, nitrogen gas) at a portion around a bump in which sealing from air is actually required, thereby preventing secondary oxidation of the bump more surely.

To accomplish the above object, a method according to the present invention for mounting a chip by bonding a bump formed on at least one of the chip and a substrate to an electrode formed on the other, comprises the steps of supplying purge gas locally at least around the bump while maintaining a gap between the chip and the substrate to be open, and bonding the bump to the electrode in the purge gas atmosphere.

As the purge gas employed in the present invention, inert gas such as nitrogen gas and argon gas, reducible gas, substitutional gas (for example, gas substitutable with a fluorine group at the surface of a bump), etc. can be used. Namely, gas, which can purge the gas forming an oxidization atmosphere represented by air and can form a non-oxidization atmosphere, may be used. Further, in the present invention, the "chip" includes all objects with forms being bonded to a substrate such as an IC chip, a semiconductor chip, an optoelectronic element and a wafer. Further, the "substrate" includes all objects with forms being bonded to a chip, a wafer, etc., such as a resin substrate, a glass substrate and a film substrate.

In the present invention, the bump is formed on at least one of the chip and the substrate. Namely, there are (A) a case where the bump is formed on the chip and the electrode is formed on the substrate, (B) a case where the bump is formed on the substrate and the electrode is formed on the chip, and (C) a case where the bump is formed on each of the chip and the substrate. Therefore, in the case of (C), the "electrode" according to the present invention means a technical concept including a bump.

In the chip mounting method according to the present invention, the purge gas is supplied locally at a low velocity so that circumambient air is not involved. For example, the purge gas is flown into the gap between the chip and the substrate from the side direction thereof substantially at a laminar flow. Alternatively, the purge gas is blown slowly at least toward a portion around the bump from a nozzle provided in a tool holding the chip.

Further, in order to prevent a great reduction of a heating temperature caused by blowing of the purge gas when the bump is bonded, the purge gas is supplied around the bump preferably after being heated.

A chip mounting apparatus according to the present invention which has a tool holding a chip and a substrate holding stage provided below the tool for holding a substrate and which bonds a bump formed on at least one of the chip and the substrate to an electrode formed on the other, comprises purge gas blowing means for supplying purge gas locally at least around the bump in a gap between the chip and the substrate which is open, before bonding. Where, the tool may either be provided or not be provided with a heater.

In this chip mounting apparatus, the purge gas blowing means is provided preferably exchangeably, more preferably automatically exchangeably. In such a structure, optimum purge gas blowing means can be used for each size of chip and each kind of substrate.

Further, the purge gas blowing means preferably has means for heating blown purge gas before being blown. In such a structure, the reduction of heating temperature, caused by blowing of the purge gas when the bump is bonded, can be prevented or suppressed.

Furthermore, it is preferred that means for controlling a flow velocity or flow rate of blown purge gas is connected to the purge gas blowing means. By such flow rate control means, optimum blowing of purge gas, in which involvement of air is suppressed, becomes possible.

In the above-described chip mounting method and apparatus according to the present invention, because the purge gas is blown into gap between the chip and the substrate at a condition where the gap is open, a particular portion, through which air is easily involved (for example, the open portion 108 shown in Fig. 7) in a conventional chamber system, is not formed. Moreover, because the opening state is formed without existence of a chamber, it becomes possible that the purge gas is blown at a condition where the nozzle of the purge gas is approached to the lower surface of the chip, particularly, to the bump. By controlling the flow velocity of the blown purge gas at a flow velocity at which a large amount of circumambient air is not involved, for example, at a low flow velocity at which a laminar flow is formed, in spite of a relatively small amount of blown purge gas, the blown purge gas can efficiently be flown or stored around the bump, and the concentration of the purge gas around the bump can be maintained at a high concentration. Consequently, the secondary oxidation of the bump can be effectively prevented, and the bump can be bonded to the electrode at a desirable condition with no secondary oxidation. As a result, the chip can be mounted on the substrate at a desirable condition efficiently and easily.

Further, if the purge gas blowing means is provided automatically exchangeably, an optimum bonding can be realized depending upon the size of the chip, etc. Furthermore, if the purge gas is heated before being blown, the reduction of the temperature of the bonding portion caused by blowing of the purge gas can be suppressed, and the bump can be bonded to the electrode more efficiently in a short period of time.

### Brief explanation of the drawings

Figure 1 is a schematic partial side view of a chip mounting apparatus according to an embodiment of the present invention.

Figure 2 is a schematic vertical sectional view showing a state after bonding of a chip and a substrate in the apparatus shown in Fig. 1.

Figure 3 is a schematic partial side view of a chip mounting apparatus according to another embodiment of the present invention.

Figure 4 is a schematic vertical sectional view of the tool side of a chip mounting apparatus according to a further embodiment of the present invention.

Figure 5 is a cross-sectional view of the apparatus shown in Fig. 4 as viewed along V-V line of Fig. 4.

Figure 6 is a cross-sectional view of the apparatus shown in Fig. 4 as viewed along VI-VI line of Fig. 4.

Figure 7 is a schematic view of a conventional chip mounting apparatus.

### The Best mode for carrying out the Invention

Hereinafter, desirable embodiments of the present invention will be explained referring to figures.

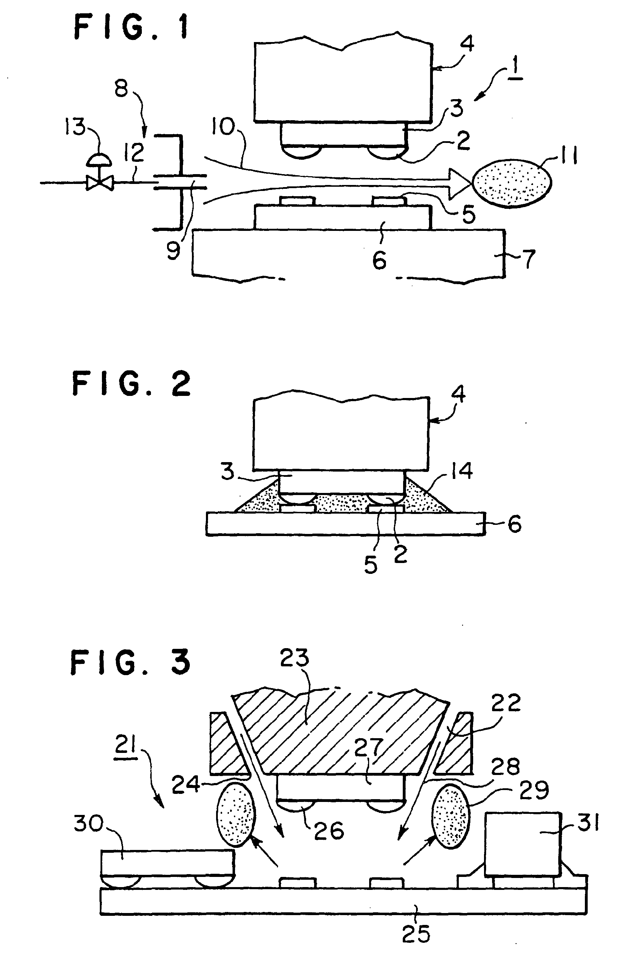

Fig. 1 shows a state immediately before chip mounting in a chip mounting method according to an embodiment of the present invention, and shows a case where bumps are formed on the chip side and electrodes are formed on the substrate side. In Fig. 1, chip mounting apparatus 1 has a tool 4 for holding a chip 3 formed with bumps 2 (for example, solder bumps) by suction, etc., and a substrate holding stage 7 for holding a substrate 6 formed with electrodes 5 by suction, etc. A heater is incorporated into the tool 4, and after the bumps 2 are brought into contact with the electrodes 5 by moving the chip 3 down, the bumps 2 are heated and molten to be bonded to the electrodes 5.

Before bonding, the gap portion between chip 3 and substrate 6 is in an open state where a chamber and the like does not exist, and at the side of this gap, purge gas blowing means 8 is provided for blowing purge gas locally. In this embodiment, nitrogen gas is used as the purge gas to be blown. Purge gas blowing means 8 may be provided movably and may be disposed fixedly. A nozzle 9 is provided in purge gas blowing means 8, and purge gas 10 (nitrogen gas) is blown from the nozzle 9 particularly locally toward a portion around bumps 2. By this blowing of the purge gas 10, the air 11 having existed in the gap between chip 3 and substrate 6 is pushed out in the opposite side direction, and especially the atmosphere in the portion around bumps 2 is substituted for the purge gas and converted into a non-oxidization atmosphere.

In this substitution by the purge gas, in order to push the air out efficiently and to involve the air from the circumstances as little as possible, it is necessary to suppress the flow velocity of the purge gas to be low. For example, the flow velocity is preferably suppressed at a low velocity such that the flow of the purge gas becomes a laminar flow. In order to control the blowing velocity at such a low velocity, a flow rate control valve 13 capable of controlling the flow velocity or the flow rate of the blown purge gas is provided on flow path 12 which supplies the purge gas to nozzle 9. The upstream side of flow rate control valve 13 may be connected to an appropriate purge gas supply source (not shown).

In chip mounting apparatus 1 thus constructed, before chip 3 is bonded to substrate 6, especially the air around bumps 2 of chip 3 is eliminated by the purge gas blown from the purge gas blowing means 8, and substituted for the purge gas. At that time, because the involvement of air from the circumstances is also suppressed, at least the portion around bumps 2 can be maintained locally at a high purge gas concentration. Therefore, the secondary oxidation of the bumps before bonding can be prevented extremely efficiently. In this condition, bumps 2 are brought into contact with electrodes 5 of the substrate, and bonded to the electrodes 5 by being heated and molten. Because occurrence of secondary oxidation is prevented, bumps 2 and electrodes 5 can be bonded well to each other electrically without any inconvenience.

In this bonding operation, for example, as shown in Fig. 2, underfill agent 14 may be charged between chip 3 and substrate 6 before or after bonding. By charging the underfill agent 14, the bonding portion can be sealed from the external atmosphere, and at the same time, the chip 3 and the substrate 6 can be bonded more strongly.

Fig. 3 shows a chip mounting apparatus 21 according to another embodiment of the present invention. In this embodiment, purge gas blowing means 22 is constructed integrally with tool 23. Purge gas nozzle 24 is opened on the lower surface of tool 23 toward an oblique downward direction, and purge gas 28 is blown toward a substrate 25, particularly toward the lower surface side of a chip 27 formed with bumps 26. Blown purge gas 28 pushes out the air 29 having existed between the chip 27 and the substrate 25, especially, the air around bumps 26. Also in this blowing of the purge gas, similarly in the aforementioned embodiment, the purge gas is blown preferably slowly so that the circumambient air is not involved.

Because the purge gas is blown locally from the tool side in this embodiment, as shown in Fig. 3, in a case where there are a chip 30 and another part 31, which have been already mounted, near the portion which is to be mounted with a chip, for example, in a case of multi-chip mounting, this method and apparatus are particularly suitable.

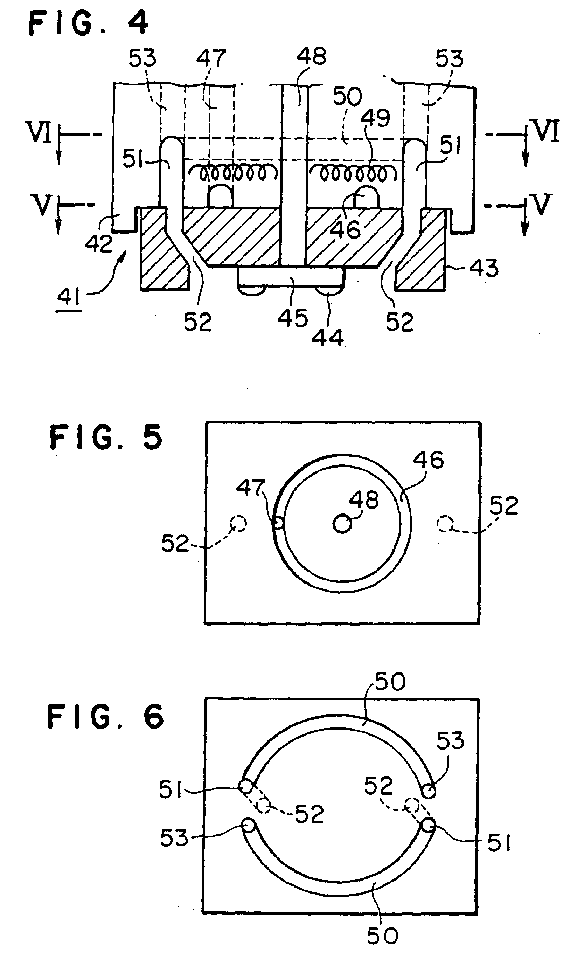

Figs. 4 to 6 show the structure of the tool side in a chip mounting apparatus according to a further embodiment of the present invention. An attachment 43, which is exchangeable, preferably automatically exchangeable, is provided on the lower end of a holder 42 of a tool 41. Chip 45 formed with bumps 44 is held by attraction on the lower surface of this attachment 43. Attachment 43 is held to be attracted on the lower surface of holder 42 by the attraction from ring-like tool attraction groove 46 formed on the lower surface of holder 42, and the attachment 43 can be easily exchanged automatically by controlling the operation of the attraction via suction path 47. Chip 45 is maintained to be attracted by the operation of the suction via a suction path 48 extending through holder 42 and attachment 43.

Heater 49 for heating the purge gas is incorporated into holder 42, and a pair of heating loops 50 extending semicircularly are formed adjacent to the portion incorporated with the heater 49 as a flow path for heating the purge gas. The purge gas is supplied into heating loops 50 from purge gas supply paths 53, and the purge gas heated in the heating loops 50 is blown out from purge gas nozzles 52 opened on the lower surface of attachment 43 through flow paths 51 extending downward. The purge gas heated is blown out at a low velocity locally toward the portion around bumps 44 of chip 45.

By heating the purge gas before being blown, the temperature reduction due to the blowing of the purge gas can be suppressed, and when bumps 44 are bonded, the bumps 44 can be thermally bonded at a condition where the high temperature is continuously maintained. Also in this embodiment, the concentration of the purge gas around bumps 44 is increased by the purge gas blown locally, and the secondary oxidation can be prevented and a desired bonding can be performed efficiently.

Further, since purge gas nozzles 52 are opened on attachment 43 and the attachment 43 can be easily exchanged automatically, an optimum purge gas blowing condition can be realized depending upon the kind and the size of chip 45.

In the above-described respective embodiments, as electrode 5 of substrate 6 or 25, all forms capable of being brought into contact with bump 2 or 26 or 44 provided on a chip, are included, such as an electrode accompanying an electric wire or a dummy electrode accompanying no electric wire.

Further, as bump 2 or 26 or 44 provided on chip 3 or 27 or 45, regardless of the electric condition of accompanying or not accompanying an electric wire, all forms capable of being brought into contact with electrode 5 provided on substrate 6 or 25, are included.

### Industrial Applications of the Invention

The chip mounting method and apparatus according to the present invention can be applied to any apparatus for mounting a chip to a substrate, and they are not limited only to a chip bonding apparatus but can be applied also to a mounter which temporarily bonds a chip. Because the secondary oxidation of a bump can be prevented effectively, a desirable bonding between a chip and a substrate can be easily performed under a desired condition.

## Claims

1. A method for mounting a chip by bonding a bump formed on at least one of the chip and a substrate to an electrode formed on the other, comprising the steps of supplying purge gas locally at least around the bump while maintaining a gap between the chip and the substrate to be open, and bonding the bump to the electrode in the purge gas atmosphere.

2. The chip mounting method according to claim 1, wherein said purge gas is flown into said gap between said chip and said substrate from the side direction thereof substantially at a laminar flow.

3. The chip mounting method according to claim 1, wherein said purge gas is blown from a nozzle provided in a tool holding said chip.

4. The chip mounting method according to any of claims 1 to 3, wherein said purge gas is supplied around said bump after being heated.

5. An apparatus for mounting a chip which has a tool holding the chip and a substrate holding stage provided below the tool for holding a substrate and which bonds a bump formed on at least one of the chip and the substrate to an electrode formed on the other, comprising purge gas blowing means for supplying purge gas locally at least around the bump in a gap between the chip and the substrate which is open, before bonding.

6. The chip mounting apparatus according to claim 5, wherein said purge gas blowing means is provided exchangeably.

7. The chip mounting apparatus according to claim 5, wherein said purge gas blowing means has means for heating blown purge gas before being blown.

8. The chip mounting apparatus according to any of claims 5 to 7, wherein means for controlling a flow velocity or flow rate of blown purge gas is connected to said purge gas blowing means.
